Europäisches Patentamt

European Patent Office

Office européen des brevets

(19)

(11) Numéro de publication : **0 006 053**
**B1**

(12) **FASCICULE DE BREVET EUROPÉEN**

(45) Date de publication du fascicule du brevet :
26.01.83

(51) Int. Cl.³ : **H 01 L 27/10**, H 03 H 15/02,
H 03 H 11/26

(21) Numéro de dépôt : **79400329.3**

(22) Date de dépôt : **23.05.79**

(54) **Dispositif différentiel à transfert de charges électriques, filtre et ligne à retard comportant un tel dispositif.**

(30) Priorité : **26.05.78 FR 7815797**

(43) Date de publication de la demande :
**12.12.79 Bulletin 79/25**

(45) Mention de la délivrance du brevet :
**26.01.83 Bulletin 83/04**

(84) Etats contractants désignés :
**DE GB NL**

(56) Documents cités :
**FR A 2 349 236**
**FR A 2 390 853**
**IEEE JOURNAL OF SOLID STATE CIRCUITS ; vol.
SC-12, n° 6, décembre 1977, New York (US)
J.L. BERGER et al. : « Cancellation of Aliasing in
CCD Low-Pass Filters » pages 617-625.**

(73) Titulaire : **THOMSON-CSF**
**173, Boulevard Haussmann**
**F-75379 Paris Cedex 08 (FR)**

(72) Inventeur : **Berger, Jean-Luc**
**"THOMSON-CSF" - SCPI 173, bld Haussmann**
**F-75360 Paris Cedex 08 (FR)**
Inventeur : **Coutures, Jean-Louis**
**"THOMSON-CSF" - SCPI 173, bld Haussmann**
**F-75360 Paris Cedex 08 (FR)**

(74) Mandataire : **Benoit, Monique et al**
**THOMSON-CSF SCPI 173, Bld Haussmann**
**F-75379 Paris Cedex 08 (FR)**

EP 0 006 053 B1

Jouve, 18, rue St-Denis, 75001 Paris, France

## Dispositif différentiel à transfert de charges électriques, filtre et ligne à retard comportant un tel dispositif

L'invention se rapporte aux dispositifs utilisant le transfert de charges dans un semiconducteur. Elle a plus particulièrement pour objet l'utilisation de tels dispositifs pour la réalisation d'un étage différentiel. Elle a également pour objet l'application d'un tel étage différentiel notamment à la réalisation d'un filtre et d'une ligne à retard à transfert de charges.

Dans un certain nombre de dispositifs à transfert de charges, il est nécessaire de disposer d'un dispositif différentiel et c'est par exemple le cas pour l'étage de sortie des filtres dits transversaux. Cet étage de sortie est classiquement réalisé à l'aide d'un amplificateur différentiel extérieur, ou encore à l'aide de transistors MOS intégrés sur le même substrat que le filtre lui-même. Toutefois ces réalisations présentent différents inconvénients, parmi lesquels on peut citer l'encombrement dans le cas d'un amplificateur différentiel extérieur, la grande consommation dans le cas de transistors MOS, la consommation de ceux-ci étant très supérieure à celle de dispositifs à transfert de charges, et les non-linéarités susceptibles d'être introduites par des transistors MOS.

Afin d'éviter ces inconvénients, il a été proposé de réaliser l'étage différentiel par la technique du transfert de charges. En particulier, on connaît l'intégration de l'étage différentiel de sortie d'un filtre dans ce dernier, décrite dans la demande de brevet français n° 75-6252 (n° de publication : 2 302 636) au nom de THOMSON-CSF, et qui consiste principalement en la mise en parallèle de deux filtres fonctionnant en opposition de phase. Les inconvénients de cette solution sont notamment l'encombrement (elle nécessite deux filtres identiques) et la particularité : il n'est pas possible dans cette structure d'isoler un étage différentiel utilisable dans un autre dispositif à transfert de charges.

Est également connu, par la demande de brevet français n° 2 349 236, un dispositif à transfert de charges utilisant deux canaux réunis par une électrode commune. Néanmoins, un tel dispositif ne permet pas, de par les potentiels y appliqués, de réaliser une différence entre deux signaux appliqués respectivement aux deux canaux.

La présente invention a pour objet un dispositif à transfert de charges qui permette de réaliser une différence mais ne présente pas les inconvénients mentionnés plus haut, et qui peut être utilisé pour des applications variées.

Selon l'invention, un dispositif différentiel à transfert de charges électriques, assure l'élaboration de la différence entre deux signaux électriques d'entrée et comporte un substrat semiconducteur dans lequel des charges électriques sont susceptibles d'être transférées à l'aide d'électrodes disposées sur le substrat sensiblement parallèles les unes aux autres et sur commande de potentiels périodiques appliqués à ces électrodes ; ce dispositif comporte en outre :

— au moins deux canaux électriquement isolés, réalisés dans le substrat, recevant respectivement les deux signaux d'entrée ;

— des premiers moyens assurant, dans chacun des canaux, l'élaboration de paquets de charges représentant des échantillons des signaux d'entrée ;

— une électrode commune aux deux canaux ;

— des seconds moyens comportant des électrodes dites de transfert, auxquelles sont appliqués des signaux périodiques de transfert commandant le transfert des charges, ces seconds moyens assurant, dans chacun des canaux, la propagation des paquets de charges jusqu'à l'électrode commune avec un retard relatif d'un canal par rapport à l'autre égal à une demi-période (T/2) des signaux de transfert des charges ; le dispositif est caractérisé par le fait que les premiers moyens assurent l'échantillonnage des deux signaux d'entrée respectivement dans les deux canaux aux mêmes instants ; et qu'il comporte en outre des troisièmes moyens, reliés à l'électrode commune, assurant le maintien de celle-ci à un potentiel flottant pendant une fraction de la période (T) des signaux de transfert des charges, pendant laquelle ces troisièmes moyens assurent le prélèvement sur l'électrode commune d'un signal qui est fonction de la différence entre les deux signaux d'entrée et qui constitue le signal de sortie du dispositif.

D'autres objets, caractéristiques et résultats de l'invention ressortiront de la description suivante et des dessins s'y rapportant, qui représentent :

la figure 1, une vue de dessus d'un mode de réalisation du dispositif différentiel selon l'invention ;

les figures 2, a à f, des schémas expliquant le fonctionnement du dispositif de la figure 1 ;

les figures 3, a à e, des diagrammes de signaux susceptibles d'être appliqués au dispositif selon l'invention ;

la figure 4, un mode de réalisation d'un élément du dispositif de la figure 1 ;

la figure 5, un premier mode d'application du dispositif selon l'invention à la réalisation d'un filtre transversal à transfert de charges ;

la figure 6, un second mode d'application du dispositif selon l'invention à la réalisation d'un filtre transversal à transfert de charges ;

la figure 7, une autre variante permettant de réaliser un filtre à coefficients de très petite valeur ;

la figure 8, un mode d'application du filtre selon l'invention à la correction du signal de sortie d'une ligne à retard à transfert de charges ;

la figure 9, une variante de la figure précédente.

Sur ces différentes figures, les mêmes références se rapportent aux mêmes éléments.

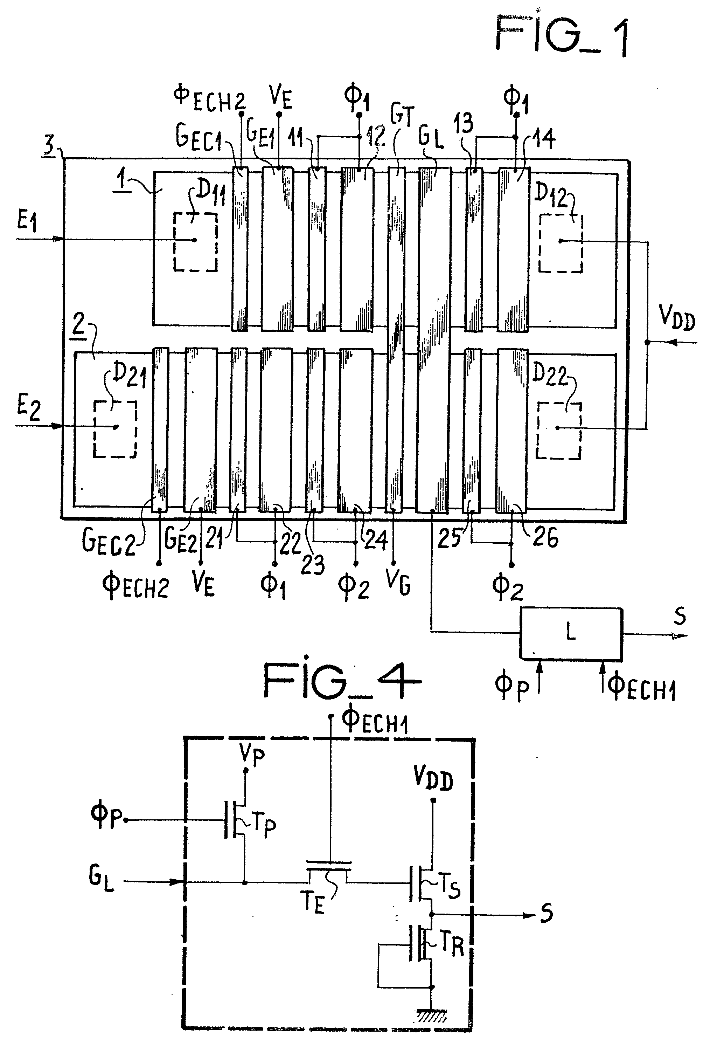

La figure 1 représente une vue de dessus du dispositif selon l'invention. Il est constitué, comme il est classique pour les dispositifs à transfert de charges, par un substrat semiconducteur (silicium par exemple) recouvert d'une couche d'isolant (oxyde de silicium par exemple) repérés 3. Dans le substrat semiconducteur sont réalisés deux canaux, 1 et 2, électriquement isolés et sensiblement parallèles entre eux, dans lesquels des charges électriques sont susceptibles d'être transférées longitudinalement. L'isolement de ces canaux peut être réalisé par tous moyens connus, notamment par une surépaisseur d'isolant ou par une augmentation locale du dopage du substrat.

Le dispositif comporte encore des électrodes déposées sur la couche d'isolant, sensiblement normalement à la direction de transfert des charges dans les canaux 1 et 2.

Dans ce mode de réalisation, le canal 1 comporte successivement : une diode d'injection $D_{11}$ ; des électrodes d'échantillonnage $G_{EC1}$ et $G_{E1}$ de transfert 11 et 12, d'arrêt $G_T$, de lecture $G_L$, de transfert 13 et 14, et une diode d'évacuation $D_{12}$. Le canal 2 comporte successivement : une diode d'injection $D_{21}$ ; des électrodes d'échantillonnage $G_{EC2}$ et $G_{E2}$, de transfert 21, 22, 23 et 24, $G_T$ et $G_L$ communes aux deux canaux, de transfert 25 et 26, et une diode d'évacuation $D_{22}$.

Les différentes diodes sont par exemple des jonctions P-N réalisées par dopage du substrat. Les diodes $D_{11}$ et $D_{21}$ sont utilisées pour réaliser l'injection dans les canaux 1 et 2 respectivement des signaux ($E_1$ et $E_2$) dont il faut faire la différence. Les diodes $D_{12}$ et $D_{22}$ sont reliées à un potentiel de polarisation $V_{DD}$ et sont utilisées pour l'évacuation des charges en fin de parcours.

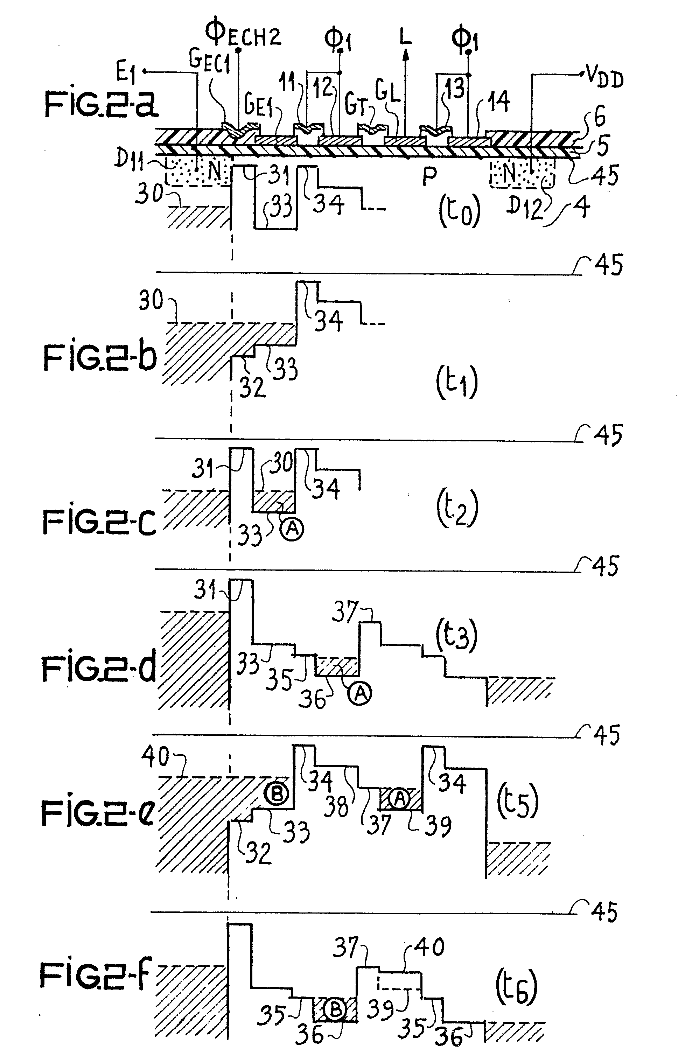

La figure 2a représente une vue en coupe du dispositif de la figure 1, réalisée dans le canal 1 selon la direction de propagation des charges. On y distingue le substrat semiconducteur (4) recouvert de la couche isolante (5). Dans le substrat 4 sont réalisées deux zones de conductivité opposée à celle du substrat, qui constituent avec ce dernier les diodes $D_{11}$ et $D_{12}$. Le substrat est porté au potentiel le plus négatif du dispositif, qui constitue le potentiel de référence (masse) par rapport auquel sont exprimés les autres potentiels.

Il est par ailleurs à noter que, dans toute la description, le substrat semiconducteur est de type P et que les charges transférées sont des porteurs minoritaires (électrons) ; il est bien entendu que pour un substrat de type N, où ce sont les trous qui se déplacent, il suffit d'inverser la polarité de tous les potentiels appliqués.

Sur la figure 2, on voit que les électrodes $G_{E1}$, 12, $G_L$ et 14 sont déposées sur la couche d'isolant 5 alors que les électrodes $G_{EC1}$, 11, $G_T$ et 13 sont déposées sur une surépaisseur d'isolant 6. Il en est de même pour le canal 2 où une électrode sur deux est déposée sur une surépaisseur d'isolant, en commençant par l'électrode $G_{EC2}$. Ainsi qu'il est connu, cette disposition a une double fonction : d'une part assurer la continuité des puits de potentiel créés dans le semiconducteur 4, et d'autre part imposer un sens de transfert unique pour les porteurs de charges. Cette structure comportant une surépaisseur d'isolant pourrait être remplacée par un surdopage du substrat, par implantation d'ions, assurant les mêmes fonctions.

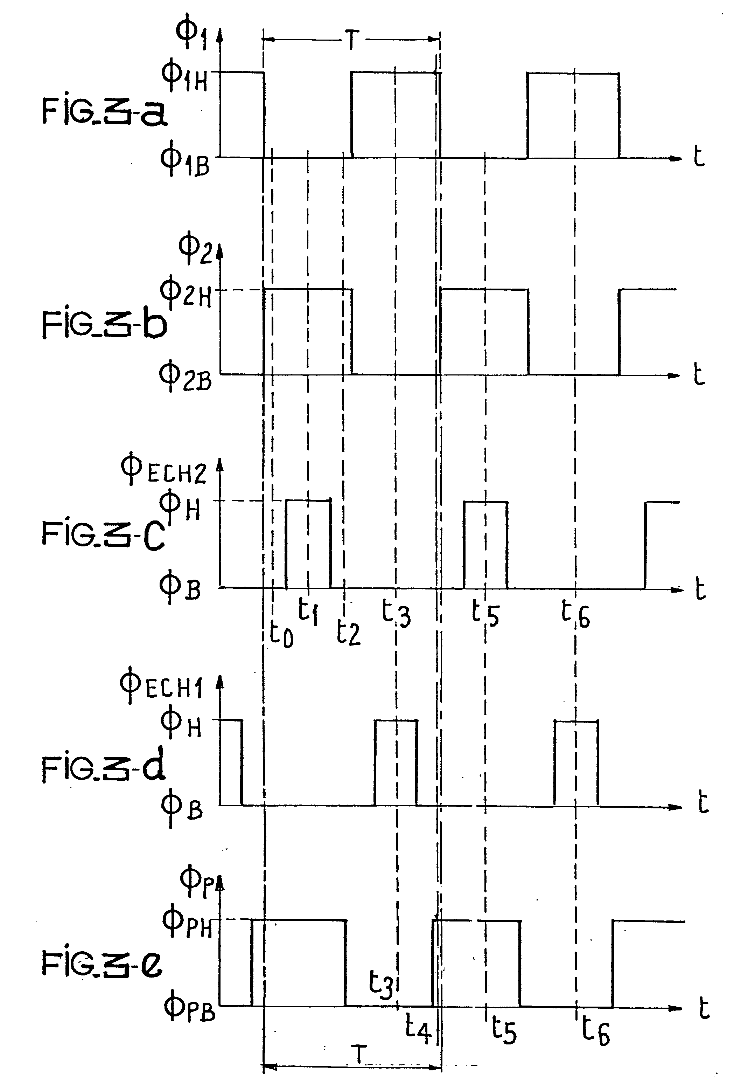

Les diagrammes de la figure 3 représentent en fonction du temps les signaux applicables au dispositif de la figure 1.

Le diagramme (a) représente un potentiel $\varnothing_1$ appliqué aux électrodes 11, 12, 13, 14, 21 et 22. C'est une fonction du type en créneaux, de période T et dont l'amplitude varie entre $\varnothing_{1B}$ (niveau bas) et $\varnothing_{1H}$ (niveau haut).

Le diagramme (b) représente un potentiel $\varnothing_2$ appliqué aux électrodes 23, 24, 25 et 26. Il est également du type fonction en créneaux et son amplitude varie entre $\varnothing_{2B}$ (niveau bas) et $\varnothing_{2H}$ (niveau haut). Il est de préférence identique à $\varnothing_1$ mais déphasé de T/2 par rapport à celui-ci.

Le diagramme (c) représente un potentiel $\varnothing_{ECH2}$ appliqué aux électrodes (ou grilles) $G_{EC1}$ et $G_{EC2}$. Il s'agit d'un signal en créneaux variant entre $\varnothing_H$ et $\varnothing_B$, de même période T que les précédents, mais pour lequel la durée du créneau inférieur ($\varnothing_{ECH2} = \varnothing_B$) est supérieure à T/2. De plus, le front de montée de $\varnothing_{ECH2}$ est en retard d'une durée inférieure à T/4 par rapport au front de montée de $\varnothing_2$.

Le diagramme (d) représente un potentiel $\varnothing_{ECH1}$ en créneaux, sensiblement de même forme que $\varnothing_{ECH2}$ mais déphasé de T/2 par rapport à ce dernier.

Le diagramme (e) représente un potentiel $\varnothing_P$ sensiblement en créneaux, dont l'amplitude varie entre $\varnothing_{PH}$ et $\varnothing_{PB}$ à la période T, et dont le front de montée se produit de préférence entre le front de descente de $\varnothing_{ECH1}$ et le front de descente de $\varnothing_1$.

Les potentiels $\varnothing_{ECH1}$ et $\varnothing_P$ sont appliqués à un élément L relié à l'électrode $G_L$ ; cet élément réalise la lecture de la quantité de charges présentes sous l'électrode $G_L$ pendant le niveau haut ($\varnothing_H$) de $\varnothing_{ECH1}$, et fixe le potentiel de ce même électrode à la valeur $\varnothing_{PH}$ avant la phase de lecture.

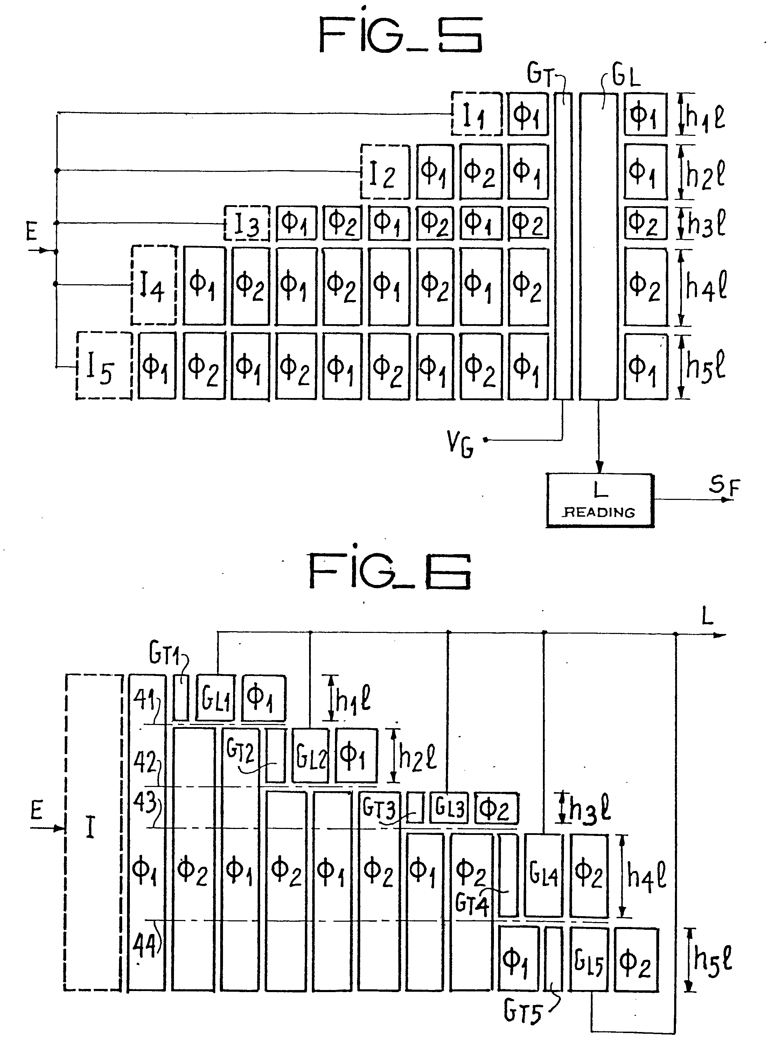

Un exemple de réalisation d'un tel élément est donné figure 4 : il comporte au moins deux transistors $T_P$ et $T_E$, du type MOS à enrichissement par exemple, connectés de la façon suivante : une borne de $T_P$ est connectée à une borne de $T_E$ et à la grille $G_L$ ; la seconde borne de $T_P$ est connectée à un potentiel constant $V_P$ et la grille de $T_P$ est reliée à $\varnothing_P$ ; la grille de $T_E$ est reliée à $\varnothing_{ECH1}$. La seconde borne de $T_E$ est connectée de préférence à la grille d'un troisième transistor $T_S$, du type MOS à enrichissement par exemple ; une borne de $T_S$ est connectée à un potentiel constant de valeur relativement élevée ($V_{DD}$) ; la seconde borne de $T_S$ fournit le signal de lecture S et est reliée à la masse par l'intermédiaire d'un élément résistif, qui peut être par exemple constitué par un transistor MOS à déplétion $T_R$ : une borne de $T_R$ est reliée à $T_S$, l'autre borne de $T_R$ et sa grille étant reliées à la masse.

Pour rendre plus clair le fonctionnement du dispositif, on a représenté sur la figure 2a l'état des puits de potentiels créés dans le substrat 4

par application des différents signaux à un instant $t_0$.

Au droit de la diode $D_{11}$, l'application du signal $E_1$ correspond à un niveau de potentiel illustré sur la figure par une ligne 30. A l'instant $t_0$, illustré sur les diagrammes de la figure 3, on a $\emptyset_{ECH2} = \emptyset_B$ sur la grille $G_{EC1}$ (ligne 31) qui interdit tout transfert des charges dans le reste du canal.

Sur le diagramme (b) de la figure 2, on a seulement représenté l'interface 45 du substrat 4 avec l'isolant 5, et l'état des puits de potentiels à un instant ultérieur $t_1$. Sur la grille $G_{EC1}$, le potentiel $\emptyset_{ECH2}$ est passé à la valeur $\emptyset_H$ (ligne 32). Par ailleurs, la grille $G_{E1}$ est maintenue à un potentiel $V_E$ qui correspond à un niveau de potentiel 33 sur la figure. Le potentiel $V_E$ peut être constant ou périodique, mais doit toujours être supérieur au signal d'entrée $E_1$ au moment de l'injection c'est-à-dire lorsque $\emptyset_{ECH2} = \emptyset_H$. A l'instant $t_1$, le potentiel $\emptyset_1$ appliqué sur l'électrode 11 étant toujours au niveau $\emptyset_{1B}$ (ligne 34), interdisant ainsi aux charges l'accès au reste du canal, le niveau des charges se stabilise (ligne 30) sous les seules électrodes $G_{EC1}$ et $G_{E1}$.

Le diagramme (c) représente l'instant $t_2$ : le potentiel $\emptyset_1$ sur l'électrode 11 est toujours au niveau $\emptyset_{1B}$ (ligne 34) mais le potentiel $\emptyset_{ECH2}$ sur l'électrode $G_{EC1}$ est revenu au niveau $\emptyset_B$ (ligne 31), isolant ainsi sous l'électrode $G_{E1}$ une quantité de charges A, définie par la différence entre le potentiel $V_E$ et le signal $E_1$ à l'instant $t_1$, c'est-à-dire représentant un échantillon du signal $E_1$ à l'instant $t_1$.

Le diagramme (d) représente le transfert de l'échantillon A sous l'électrode 12 : au temps $t_3$, le potentiel $\emptyset_1$ passe au niveau $\emptyset_{1H}$, ce qui se traduit sous les électrodes 11 et 12 par deux niveaux différents 35 et 36 du fait que l'électrode 11 est placée sur une surépaisseur d'isolant (6). L'échantillon A ne peut toutefois pas dépasser l'électrode 12 à cause de la grille $G_T$ qui est maintenue à un potentiel constant $V_G$ (ligne 37 sur le schéma).

A un instant ultérieur $t_4$, avant que le signal $\emptyset_1$ ne revienne au niveau $\emptyset_{1B}$, dans une phase non représentée sur la figure 2, le signal $\emptyset_P$ passe au niveau $\emptyset_{PH}$ alors que $\emptyset_{ECH1}$ est au niveau bas ($\emptyset_B$) (voir figure 3) ; cela a pour effet de fixer le potentiel de l'électrode $G_L$ à un niveau $V_P$ par l'action du transistor $T_P$ de la figure 4.

Le diagramme 2e représente à un instant $t_5$ le transfert de l'échantillon A sous l'électrode $G_L$, celle-ci étant toujours maintenue au potentiel $V_P$ (ligne 39). Ce transfert est permis par le retour de $\emptyset_1$ à la valeur $\emptyset_{1B}$ sur les électrodes 12 et 13 entourant la grille $G_L$. Simultanément, commence l'élaboration d'un second échantillon (B), dans une phase analogue à la phase (b) au temps $t_1$ pour l'échantillon A.

Le diagramme 2f représente à un instant $t_6$ la phase de lecture de la quantité (A) de charges présente sous la grille $G_L$.

Le potentiel $\emptyset_1$ passant au niveau $\emptyset_{1H}$, les charges du canal 1 sont évacuées vers la diode $D_{12}$ tandis que, dans le canal 2, les charges arrivent sous l'électrode $G_L$ : en effet, le canal 2 comporte une paire d'électrodes de plus que le canal 1, entre les électrodes 21 et 22 et la grille $G_T$, commandées par le potentiel $\emptyset_2$. Le potentiel de la grille $G_L$ étant flottant depuis que $\emptyset_P = \emptyset_{PB}$ (instant ($t_6$)), il se fixe alors à une valeur proportionnelle à la différence entre la quantité de charges qui arrive (canal 2) et la quantité de charges qui parte (canal 1). Le potentiel $\emptyset_{ECH1}$ permet de prélever l'information à cet instant sur le MOS d'échantillonnage $T_E$. Par ailleurs, en ce qui concerne l'échantillon B, l'instant $t_6$ est analogue à l'instant $t_3$ pour l'échantillon A.

A l'instant suivant, les charges du canal 2 (échantillon B) sont évacuées par le potentiel $\emptyset_2$ et un nouveau paquet de charges arrive sous $G_L$ par le canal 1.

Dans le dispositif décrit ci-dessus, il est nécessaire que la valeur de l'amplitude $\emptyset_{1H}$ soit grande par rapport à la valeur du potentiel $V_P$ appliqué sur la grille $G_L$ pour qu'à l'instant $t_6$, toutes les charges puissent être évacuées. Cela peut être réalisé par un réglage de $V_P$.

Toutefois, deux variantes sont possibles qui permettent de s'affranchir de l'impératif de grandeur relative entre $\emptyset_{1H}$ et $V_P$ :

— la première consiste à réaliser une diffusion conductrice entre la grille $G_L$ et l'électrode 14, l'électrode 13 étant supprimée ; cette diffusion constitue un réservoir de porteurs de charges dont le niveau s'aligne sur celui du potentiel le plus haut ;

— la seconde est utilisable lorsque, contrairement à ce qui est décrit ci-dessus, on crée selon une technique connue une dissymétrie dans le sens de transfert des charges par surdopage local (implantation d'ions par exemple) ; dans ce cas, on omet le surdopage sous l'électrode 13.

Le dispositif différentiel décrit ci-dessus réalise donc l'échantillonnage des deux signaux d'entrée ($E_1$ et $E_2$) aux mêmes instants ($\emptyset_{ECH2} = \emptyset_H$, à la période T), les échantillons correspondants arrivant à une électrode commune ($G_L$) avec un déphasage de T/2, qui est introduit par la différence dans le nombre d'électrodes de transfert placées respectivement sur chaque canal. Cette disposition permet d'éviter un maintien extérieur des signaux pendant une demi-période, maintien qui serait nécessaire si l'échantillonnage s'effectuait dans chaque canal avec un retard relatif de T/2. Cette disposition permet en outre une différenciation automatique des signaux, puisqu'ils parviennent en opposition de phase à l'électrode ($G_L$) où s'opère la lecture.

La figure 5 représente un premier mode d'application du dispositif selon l'invention à la réalisation d'un filtre transversal à transfert de charges, utilisant la technique des charges couplées ou CCD (pour Charge Coupled Devices).

On rappelle que pour réaliser un filtre à l'aide d'un dispositif à transfert de charges, il est nécessaire d'échantillonner le signal, de le faire passer dans une ligne à retard comportant un nombre discret N d'étages, de le prélever au niveau de chaque étage et de l'affecter d'un coefficient de pondération $h_i$ ($1 \leqslant i \leqslant N$) dépendant du filtrage recherché, puis d'additionner algébriquement les signaux ainsi produits pour obtenir le signal filtré.

Sur la figure 5, pour simplifier le dessin, on n'a représenté le filtre que par ses électrodes, celles-ci étant classiquement isolées les unes des autres, déposées sur un substrat semiconducteur recouvert d'une couche d'isolant. Le filtre comporte $N = 5$ étages, réalisés par cinq canaux sensiblement parallèles, la largeur des canaux variant avec les coefficients de pondération : elle est de la forme $h_i.l$, avec :

— $h_i$ : le coefficient sans dimension, $1 \leqslant i \leqslant 5$ ;
— $l$ : largeur unitaire.

Dans chaque canal circule alors une quantité de charges proportionnelles au coefficient $h_i$. Chaque canal comporte : un étage ($I_1...I_5$) d'injection des charges dans le canal, représenté sur la figure par un bloc en traits pointillés symbolisant la diode D et les grilles $G_{EC}$ et $G_E$ décrites précédemment ; un ensemble d'électrodes de transfert reliées alternativement aux potentiels $\emptyset_1$ et $\emptyset_2$ précédents, en nombre fonction du rang du canal et du signe du coefficient de pondération recherché. Comme pour le dispositif de la figure 1, les grilles $G_T$ et $G_L$ s'étendent sur l'ensemble des canaux, la première étant maintenue au potentiel $V_G$ et la seconde reliée à l'élément L. Egalement comme sur la figure 1, chaque canal comporte, après les grilles $G_T$ et $G_L$, une électrode de transfert puis une diode d'évacuation des charges (non représentée).

Il est à noter qu'on entend par « électrode de transfert » dans cette figure comme dans les suivantes, une paire de deux électrodes telles que 11 et 12 ou 23 et 24 de la figure 1, connectées au même potentiel $\emptyset_1$ ou $\emptyset_2$.

En ce qui concerne le retard apporté au signal d'entrée dans chaque canal, il est bien entendu fonction du nombre d'électrodes de transfert que comporte le canal considéré, deux électrodes successivement commandées respectivement par $\emptyset_1$ et $\emptyset_2$ apportant un retard T. En conséquence, pour que chaque étage apporte un retard supplémentaire T par rapport au précédent, il est nécessaire que le canal correspondant comporte deux électrodes de transfert supplémentaires : c'est ce qui est représenté figure 5 où le second canal par exemple comporte, après l'étage d'injection $I_2$, deux électrodes ($\emptyset_2$ et $\emptyset_1$) de plus que le premier canal, qui n'en comporte qu'une ($\emptyset_1$).

En ce qui concerne le signe des coefficients de pondération, il peut être positif ou négatif. Par application du principe de l'étage différentiel de la figure 1, on réalise l'injection du signal E en phase, c'est-à-dire au même instant, dans tous les canaux, et on ajoute une électrode de transfert supplémentaire aux canaux représentant des coefficients positifs. De cette façon, les paquets de charges correspondant aux coefficients de même signe sont additionnés entre eux et viennent se soustraire aux paquets de charges représentant des coefficients de signes opposés, du fait qu'ils rejoignent les électrodes communes $G_T$ et $G_L$ avec un retard relatif de T/2. On obtient donc à la sortie du bloc L le signal $S_F$ de sortie du filtre.

Une telle réalisation a pour avantages, par rapport à d'autres filtres transversaux connus :

— d'une part, d'être entièrement intégrale sur le même substrat, étages différentiels compris ;
— d'autre part, d'éviter tout prélèvement et toute sortie du signal hors du dispositif à transfert de charges avant l'obtention du signal somme $S_F$.

La figure 6 représente un autre mode d'application du dispositif selon l'invention à la réalisation d'un filtre transversal à transfert de charges.

Comme sur la figure précédente, le filtre n'est représenté que par ses électrodes. De plus, pour simplifier, on a choisi les mêmes coefficients que sur la figure 5, avec le même nombre d'étages ($N = 5$).

Dans ce mode de réalisation, l'étage d'injection (I) est commun à tous les canaux, ainsi que la première électrode de transfert commandée par le potentiel $\emptyset_1$. Toutefois, les canaux sont isolés les uns des autres par exemple par des diffusions d'isolement (lignes 41 à 44 sur la figure) qui commencent sous l'électrode $\emptyset_1$, afin d'obtenir une meilleure précision comme décrit dans la demande de brevet français n° 77-28737 au nom de THOMSON-CSF.

Le premier canal, de largeur $h_i.l$, comporte après les électrodes $G_T$ et $G_L$ une électrode de transfert $\emptyset_1$ puis une diode (non représentée). Le second canal, pour conférer aux charges un retard T par rapport à celles du premier canal, comporte outre l'électrode $\emptyset_1$ commune à tous les canaux et les grilles $G_T$ et $G_L$, deux électrodes de transfert supplémentaire ($\emptyset_2$ et $\emptyset_1$), qui sont communes aux quatre canaux restants, etc.

Les différentes grilles $G_L$ sont reliées au bloc de lecture L pour fournir le signal de sortie du filtre, le signe des coefficients de pondération du filtre étant obtenu comme dans le dispositif de la figure 5 par un déphasage de T/2.

Ce mode de réalisation permet d'ajouter si nécessaire une ligne à retard au filtre, ligne à retard qui se traduit par un certain nombre de paires d'électrodes de transfert ($\emptyset_1$, $\emptyset_2$) communes à l'ensemble des canaux, placées entre l'étage d'injection I et l'électrode de transfert sous laquelle est réalisée la séparation des canaux.

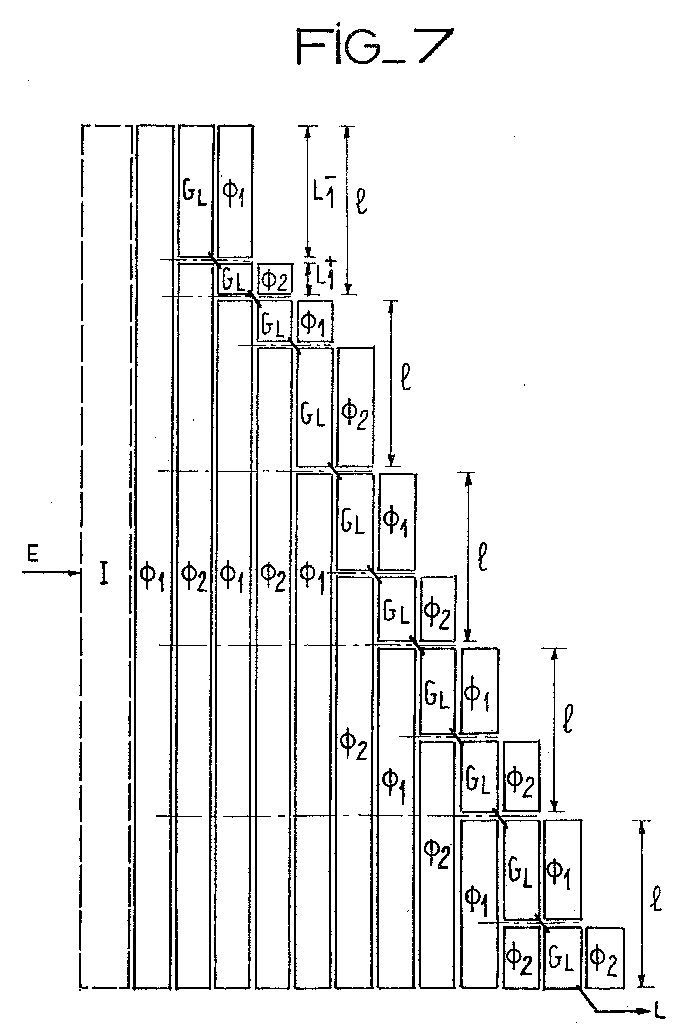

La figure 7 représente un autre mode d'application du dispositif selon l'invention, permettant de réaliser un filtrage avec des coefficients de très petite valeur.

La figure 7 représente, comme précédemment, un filtre à N canaux, avec $N = 5$, avec un étage d'injection (I) et une première électrode de transfert ($\emptyset_1$) commune, la séparation entre les canaux s'effectuant sous cette électrode.

Dans ce mode de réalisation, tous les canaux ont la même largeur (l), mais chaque canal est ensuite partagé en deux parties ($L^+$ et $L^-$) proportionnelles à $1 + h_k/2$ et $1 - h_k/2$ respectivement, après ($k - 1$) étages de transfert ($k \leqslant N$). Chaque

canal comporte ensuite un étage différentiel analogue à celui de la figure 1 : la partie de la largeur $L^+$ subit un transfert supplémentaire avant d'arriver sur l'ensemble des grilles $G_T$ et $G_L$, seule cette dernière étant représentée pour simplifier le dessin. Les grilles $G_L$ de tous les canaux sont reliées ensemble au bloc de lecture L pour donner la signal de sortie $S_F$.

Dans ce dispositif, la largeur des électrodes est d'autant plus grande que la valeur des coefficients est petite avec $L_k^+ = L_k^- = 1/2$ pour $h_k = 0$. Cette structure est donc particulièrement avantageuse pour la réalisation de filtres à coefficients de très petite valeur, du fait de l'impossibilité technologique qu'il y a à réaliser des largeurs de canaux très petits (inférieurs à 5 µm par exemple).

Les filtres décrits dans les figures précédentes peuvent être notamment utilisés pour la correction qui est nécessaire en sortie d'une ligne à retard à transfert de charges.

Ainsi qu'il est connu, l'atténuation d'un signal qui se propage dans une telle ligne est une fonction croissante de la fréquence de ce signal, et cette atténuation est d'autant plus forte que la fréquence-horloge de la ligne est plus élevée, ce qui constitue une limite pour l'accroissement de cette fréquence. Pour pallier ce défaut, il est d'usage de faire suivre la ligne à retard par un filtre qui a pour fonction d'uniformiser l'atténuation pour toutes les fréquences du signal, jusqu'à la demi-fréquence horloge.

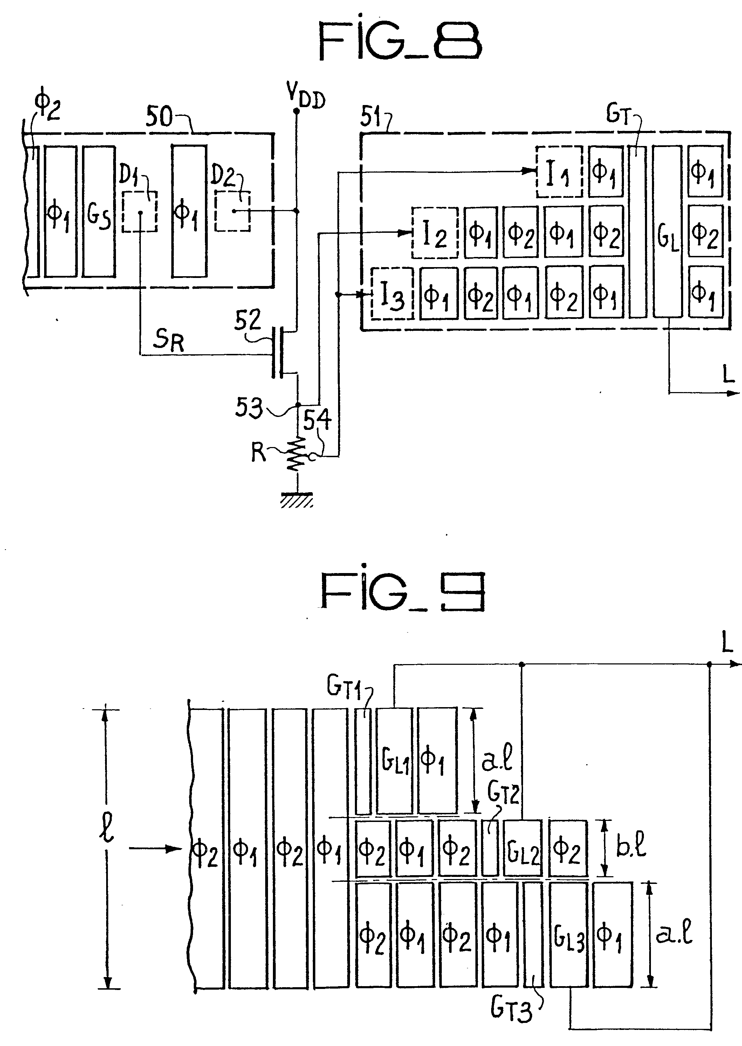

La figure 8 représente un mode d'application du filtre à transfert de charges selon l'invention à une telle correction ; cette application présente l'avantage de permettre l'intégration de la ligne à retard et du filtre correctif dans un même substrat.

Sur la figure 8, a été représentée à titre d'exemple une extrémité d'une ligne à retard à transfert de charges 50, comportant successivement les deux dernières électrodes de transfert ($\varnothing_2$ et $\varnothing_1$), une grille de sortie ($G_S$) parallèle aux électrodes précédentes, une diode $D_1$, une électrode de transfert ($\varnothing_1$) et une deuxième diode $D_2$. Le signal ($S_R$) de sortie de la ligne est obtenu sur la diode $D_1$ et alimente la grille d'un transistor MOS 52 ; une tension relativement élevée, par exemple la tension $V_{DD}$ précédente, polarise la diode $D_2$ et alimente l'une des bornes du TMOS 52, l'autre borne (53) de ce transistor étant reliée à la masse par l'intermédiaire d'un rhéostat R.

Le dispositif de la figure 8 comporte un filtre 51, analogue à celui qui est décrit figure 5, par exemple à trois coefficients ($-a$, $b = 1$, $-a$), mais dont les canaux sont de largeur identique. Le second canal qui, seul, représente un coefficient positif, implique un déphasage de $T + T/2$ par rapport au premier canal ; il reçoit sur son étage d'injection ($I_2$) le signal disponible au point 53, qui représente le coefficient de filtrage égal à l'unité. Le troisième canal présente un déphasage de 2T par rapport au premier canal ; il reçoit sur son étage d'injection ($I_3$) le même signal que le premier canal, fourni par le curseur 54 du rhéostat R, qui représente le coefficient de filtrage « a ».

Un des avantages de ce mode de réalisation est que le réglage du rhéostat R permet d'ajuster la valeur du coefficient « a », c'est-à-dire la réponse du filtre.

La figure 9 représente une variante du dispositif de la figure précédente, utilisable lorsque les coefficients (a,b) du filtre correcteur sont connus d'avance, et qui permet une réalisation plus compacte.

Sur la figure 9, on a représenté les quatre dernières électrodes de transfert ($\varnothing_2$, $\varnothing_1$, $\varnothing_2$, $\varnothing_1$) d'une ligne à retard à transfert de charges, dont le canal est de largeur 1. Sous la dernière électrode $\varnothing_1$, le canal est partagé en trois canaux de largeur a.1, b.1 et a.1, respectivement avec $2a + b = 1$, de façon à constituer un filtre analogue à celui qui est décrit figure 6. Comme précédemment, le deuxième canal représente un coefficient de filtrage positif, alors que les deux autres représentent des coefficients négatifs et présentent donc un déphasage de T/2 par rapport au second canal.

Comme sur la figure 6, les grilles $G_L$ de chaque canal ($G_{L1}$, $G_{L2}$, et $G_{L3}$) sont réunies entre elles et connectées au bloc L pour fournir le signal retardé et filtré.

Un avantage de ce mode de réalisation est qu'il n'est pas nécessaire de prélever le signal entre l'étage de retard et l'étage de correction.

De façon analogue à ce qui est représenté pour les figures 8 et 9, le filtre de la figure 7 peut être également utilisé en combinaison avec une ligne à retard à des fins de correction du signal retardé.

## Revendications

1. Dispositif différentiel à transfert de charges électriques, assurant l'élaboration de la différence entre deux signaux électriques d'entrée ($E_1$, $E_2$), comportant un substrat semiconducteur (4) dans lequel des charges électriques sont susceptibles d'être transférées à l'aide d'électrodes disposées sur le substrat sensiblement parallèles les unes aux autres, et sur commande de potentiels périodiques appliqués à ces électrodes ; ce dispositif comportant en outre :

— au moins deux canaux (1, 2) électriquement isolés, réalisés dans le substrat, recevant respectivement les deux signaux d'entrée ($E_1$, $E_2$) ;

— des premiers moyens assurant, dans chacun des canaux (1, 2), l'élaboration de paquets de charges représentant des échantillons des signaux d'entrée ($E_1$, $E_2$) ;

— une électrode commune ($G_L$) aux deux canaux (1, 2) ;

— des seconds moyens comportant des électrodes dites de transfert, auxquelles sont appliqués des signaux périodiques de transfert ($\varnothing_1$, $\varnothing_2$) de période (T) commandant le transfert des charges, ces électrodes étant en nombre tel que dans chacun des canaux, les paquets de charges arrivent à l'électrode commune ($G_L$) avec un retard relatif d'un canal par rapport à l'autre égal à une demi-période (T/2) ; ledit dispositif étant caractérisé par le fait que les premiers moyens assurent l'échantillonnage des deux signaux d'entrée ($E_1$, $E_2$) respectivement dans les deux canaux (1, 2) aux mêmes instants et qu'il comporte en outre des troisièmes moyens (L), reliés à l'électrode commune ($G_L$) permettant son flottement à l'instant ($t_6$) auquel ces troisièmes moyens assurent l'échantillonnage sur l'électrode commune ($G_L$) d'un signal qui est fonction de la différence entre les deux signaux d'entrée ($E_1$, $E_2$) et qui constitue le signal de sortie du dispositif.

2. Dispositif différentiel selon la revendication 1, caractérisé par le fait que les troisièmes moyens (L) assurent dans un premier temps ($t_4$) l'application d'un potentiel constant ($V_P$) à l'électrode commune ($G_L$) lors de l'arrivée ($t_5$) des paquets de charges dans le premier canal (1) sous cette électrode, puis, dans un second temps, l'isolation de l'électrode commune ($G_L$) et la lecture de son potentiel qui résulte du potentiel constant ($V_P$) précédent et de la quantité de charges qui est présente sous l'électrode lors de l'arrivée du paquet de charges dans le second canal (2) et du départ du paquet de charges présent dans le premier canal (1).

3. Dispositif différentiel selon la revendication 2, caractérisé par le fait que les troisièmes moyens (L) comportent un premier ($T_P$) et un second ($T_E$) transistors du type MOS ; le premier ($T_P$) est relié d'une part à l'électrode commune ($G_L$) et d'autre part au potentiel constant ($V_P$), commandé par un premier potentiel ($\varnothing_P$) de même période (T) que les signaux de transfert ($\varnothing_1$, $\varnothing_2$), déphasé par rapport à ces derniers de sorte que l'électrode commune ($G_L$) soit déjà portée au potentiel constant ($V_P$) lors de l'arrivée des paquets de charges dans un premier canal (1) ; le second transistor MOS ($T_E$) est relié par l'une de ses bornes à l'électrode commune ($G_L$) et sur l'autre de ses bornes fournit le signal de sortie (S) du dispositif, ce second transistor étant commandé par un second potentiel ($\varnothing_{ECH1}$) de même période (T) que le précédent ($\varnothing_P$) mais qui est à un niveau haut au plus pendant la durée où le premier potentiel ($\varnothing_P$) est au niveau bas.

4. Dispositif différentiel selon l'une des revendications précédentes, caractérisé par le fait que les premiers moyens sont constitués, pour chaque canal, par une diode (D) réalisée dans le substrat, une première ($G_{EC}$) et une seconde ($G_E$) électrodes, ou grilles, sensiblement parallèles aux électrodes de transfert, le signal d'entrée (E) du canal étant appliqué à la diode (D), la première grille ($G_{EC}$) étant commandée par un potentiel périodique ($\varnothing_{ECH2}$) identique pour les deux canaux, de même période (T) que les signaux de transfert ($\varnothing_1$, $\varnothing_2$), permettant l'échantillonnage du signal d'entrée (E).

5. Dispositif différentiel selon l'une des revendications précédentes, caractérisé par le fait que chaque électrode de transfert se décompose en deux électrodes commandées par le même signal de transfert, ces électrodes étant placées sur le substrat (4) par l'intermédiaire de couches (5, 6) de matériaux électriquement isolants d'épaisseurs différentes, de sorte que le transfert des charges dans le substrat ne puisse s'effectuer que dans un seul sens.

6. Dispositif différentiel selon l'une des revendications précédentes, caractérisé par le fait que l'électrode commune ($G_L$) est précédée par une seconde électrode ($G_T$) également commune maintenue à un potentiel constant ($V_G$) tel que le transfert des charges dans le substrat ne puisse s'effectuer que vers ladite électrode commune ($G_L$).

7. Filtre utilisant le transfert de charges dans un semiconducteur, assurant le filtrage d'un signal d'entrée (E) à l'aide d'un nombre (N) de coefficients de pondération, caractérisé par le fait qu'il comporte un dispositif différentiel selon la revendication 1 et des canaux supplémentaires de sorte que le filtre comporte autant de canaux que de coefficients de filtrage, le nombre d'électrodes de transfert dans chaque canal étant tel que d'une part les paquets de charges parcourant respectivement deux canaux adjacents représentant des coefficients de même signe soient déphasés l'un par rapport à l'autre de la période (T) des signaux de transfert, et d'autre part les paquets de charges parcourant respectivement deux canaux adjacents représentant des coefficients de signe contraire soient déphasés d'un nombre impair de demi-périodes (T/2) des signaux de transfert.

8. Filtre selon la revendication 7 et l'une des revendications précédentes, caractérisé par le fait que les canaux sont disposés sensiblement parallèlement les uns aux autres, leur largeur définissant la grandeur du coefficient de filtrage correspondant, chaque canal comportant des moyens d'échantillonnage du signal d'entrée (E) et l'électrode commune ($G_L$) s'étendant sur l'ensemble des canaux.

9. Filtre selon la revendication 7, caractérisé par le fait que les canaux sont disposés sensiblement parallèlement les uns aux autres, leur largeur définissant la grandeur du coefficient de filtrage correspondant, les moyens d'échantillonnage du signal d'entrée (E) étant communs à l'ensemble des canaux et l'électrode commune ($G_L$) étant constituée d'autant d'électrodes que de canaux, électriquement reliées entre elles.

10. Filtre selon la revendication 7, caractérisé par le fait que les canaux sont disposés sensiblement parallèlement les uns aux autres et sont de même largeur, les moyens d'échantillonnage du signal d'entrée (E) étant communs à l'ensemble des canaux, chacun des canaux étant divisé en deux parties ($L^+$, $L^-$) dont le rapport des largeurs représente le coefficient de filtrage correspondant, l'électrode commune ($G_L$) étant constituée d'autant d'électrodes que de parties de canaux, électriquement reliées entre elles.

11. Filtre selon l'une des revendications 9 ou 10, caractérisé par le fait que la première électrode de transfert, située sur le trajet des charges après les moyens d'échantillonnage, est également commune à l'ensemble des canaux, l'isolement électrique de ceux-ci débutant sous cette électrode et étant réalisé par des diffusions d'isolement.

12. Ligne à retard utilisant le transfert de charges dans un semiconducteur, conférant un retard à un signal d'entrée, caractérisée par le fait qu'elle comporte un filtre correctif selon la revendication 7.

13. Ligne à retard selon la revendication 12, caractérisée par le fait que le filtre correctif comporte des canaux de même largeur, disposés sensiblement parallèlement les uns aux autres, chaque canal comportant des moyens d'échantillonnage (I) du signal appliqué au canal, l'électrode commune ($G_L$) s'étendant sur l'ensemble des canaux, le signal retardé ($S_R$) étant appliqué aux canaux du filtre par l'intermédiaire d'éléments résistifs (R) dont la valeur de la résistance définit la valeur du coefficient de filtrage du canal correspondant.

14. Ligne à retard selon la revendication 12 et l'une des revendications 9 ou 10, caractérisée par le fait qu'elle est constituée par des électrodes de transfert s'étendant sur l'ensemble des canaux, placées sur le trajet des charges après les moyens d'échantillonnage.

**Claims**

1. Differential device for the transfer of electric charges, for determining the difference between two electric input signals ($E_1$, $E_2$), comprising a semiconductor substrate (4) in which the electric charges are adapted to being transferred by means of electrodes arranged on the substrate substantially parallel to each other, and upon control by periodic potentials applied to said electrodes ; said device further comprising :

— at least two electrically insulated channels (1, 2) provided in the substrate, receiving, respectively, the two input signals ($E_1$, $E_2$) ;

— first means to produce in each channel (1, 2) stacks of charges representing samples of the input signals ($E_1$, $E_2$) ;

— a common electrode ($G_L$) for the two channels (1, 2) ;

— second means comprising electrodes called transfer electrodes, to which are applied periodic transfer signals ($\emptyset_1$, $\emptyset_2$) of period (T) controlling the transfer of charges, said electrodes being of such a number that in each channel, the stacks of charges arrive at the common electrode ($G_L$), with a relative a delay of half a period (T/2) between said channel with respect to the other said device being characterized by the fact that the first means effect sampling of the two input signals ($E_1$, $E_2$), respectively, in the two channels (1, 2) at identical moments, said device further comprising third means (L), connected to the common electrode ($G_L$), allowing it to float at the moment ($t_6$) at which said third means sample at the common electrode ($G_L$) a signal which is a function of the difference between the two input signals ($E_1$, $E_2$) and which constitutes the output signal of the device.

2. Differential device according to claim 1, characterized in that the third means (L) apply at a first moment ($t_4$) a constant voltage ($V_p$) to the common electrode ($G_L$) at the arrival ($t_5$) of the stacks of charges in the first channel (1) under said electrode, then, at a second moment, insulate the common electrode ($G_L$) while reading its voltage which results from the preceding constant voltage ($V_p$) and the quantity of charges which is present under the electrode when the stack of charges arrives in the second channel (2) and when the stack of charges present in the first channel departs.

3. Differential device according to claim 2, characterized in that the third means (L) comprise a first ($T_p$) and a second ($T_E$) transistor of the MOS type ; with the first one ($T_p$) being connected, on the one hand, to the common electrode ($G_L$), and, on the other hand, to the constant voltage controlled by a first voltage ($\emptyset_p$) of the same period (T) as the transfer signals ($\emptyset_1$, $\emptyset_2$), phase-shifted with respect to the latter in such a way that the common electrode ($G_L$) is already brought to the constant voltage ($V_p$) when the stacks of charges arrive in a first channel (1) ; the second MOS transistor ($T_E$) being connected by one of its terminals to the common electrode ($G_L$), the output signal (S) of the device being produced at the other one of its terminals, said second transistor being controlled by a second voltage ($\emptyset_{ECH1}$) of the same period (T) as the preceding one ($\emptyset_p$), but which is at a high level, at most, during the time when the first voltage is on its low level.

4. Differential device according to one of the preceding claims, characterized in that the first means are constituted for each channel by a diode (D) provided in the substrate, a first ($G_{EC}$) and a second ($G_E$) electrode, or grid, substantially parallel to the transfer electrodes, with the input signal (E) of the channel being applied to the diode (D), the first grid ($G_{EC}$) being controlled by a periodic voltage ($\emptyset_{ECH2}$), identical for the two channels, of the same period (T) as the transfer signals ($\emptyset_1$, $\emptyset_2$), allowing sampling of the input signal (E).

5. Differential device according to one of the preceding claims, characterized in that each transfer electrode is divided into two electrodes controlled by the same transfer signal, said electrodes being placed on the substrate (4) by means of layers (5, 6) of electrically insulating materials of different thickness, in such a way that the transfer of charges in the substrate can only take place in one direction.

6. Differential device according to one of the preceding claims, characterized in that the common electrode ($G_L$) is preceded by a second electrode ($G_T$), also common, maintained at a constant voltage ($V_G$) so that the transfer of charges in the substrate can only take place toward said common electrode ($G_L$).

7. Filter using the transfer of charges in a semiconductor, effecting the filtering of an input signal (E) by means of a number (N) of weighting coefficients, characterized in that it comprises a different shell device according to claim 1 and additional channels in such a manner that the filter comprises a number of channels equal to the number of filtering coefficients, while the number of transfer electrodes in each channel is such that, on the one hand, the stacks of charges passing, respectively, through two adjacent channels representing coefficients of the same sign, are phase-shifted with respect to each other by the length of the period (T) of the transfer signals, and, on the other hand, the stacks of charges passing, respectively, through two adjacent channels representing coefficients of the opposite sign, are phase-shifted by an uneven number of half-periods (T/2) of the transfer signals.

8. Filter according to claim 7 and one of the preceding claims, characterized in that the channels are arranged substantially parallel to each other, with their width defining the value of the corresponding filtering coefficient, with each channel comprising means for sampling the input signal (E), and with the common electrode ($G_L$) extending over all of said channels.

9. Filter according to claim 7, characterized in that the channels are arranged substantially parallel to each other, with their width defining the value of the corresponding filtering coefficient, of the input signal (E) said sampling means being common to all the channels, and the common electrode ($G_L$) being formed of as many electrically interconnected electrodes as there are channels.

10. Filter according to claim 7, characterized in that the channels are arranged substantially parallel to each other and are of equal widths, with the sampling means of the input signal (E) being common to all the channels, each of the channels being divided into two portions ($L^+$, $L^-$), whose ratio of widths represents the corresponding filtering coefficient, said common electrode ($G_L$) being formed of as many electrodes as there are electrically interconnected portions.

11. Filter according to one of claims 9 or 10, characterized in that the first transfer electrode, positioned in the path of charges behind the sampling means, is also common to all the channels, with the electrical insulation thereof beginning under this electrode and being achieved by diffusion of insulating material.

12. Delay line utilizing the transfer of charges in a semiconductor, conferring a delay onto an input signal, characterized in that it comprises a corrective filter according to claim 7.

13. Delay line according to claim 12, characterized in that the corrective filter comprises channels of equal widths, arranged substantially parallel to each other, with each channel comprising sampling means (I) of the signal applied to the channel, with the common electrode ($G_L$) extending over all the channels, and the delayed signal ($S_R$) being applied to the channels of the filter by means of resistor elements (R) whose resistance value defines the value of the filtering coefficient of the corresponding channel.

14. Delay line according to claim 12 and one of claims 9 or 10, characterized in that it is formed by transfer electrodes extending over all the channels and placed in the path of charges behind the sampling means.

**Ansprüche**

1. Differentialvorrichtung für die Übertragung elektrischer Ladungen, bei der die Differenz zwischen zwei elektrischen Eingangssignalen ($E_1$, $E_2$) bestimmt wird, umfassend ein Halbleitersubstrat (4), in dem die elektrischen Ladungen mit Hilfe von auf dem Substrat im wesentlichen parallel zueinander ausgerichteten Elektroden unter dem Einfluss von an dieselben angelegten periodischen potentialen übertragbar sind, während die Vorrichtung ferner einschliesst :
— mindestens zwei elektrisch voneinander isolierte Kanäle (1, 2), die in dem Substrat angeordnet sind, und je eines der beiden Eingangssignale ($E_1$, $E_2$) aufnehmen ;
— erste Mittel, um in jedem Kanal (1, 2) Gruppen von Ladungen erzeugen die Muster der Eingangssignale ($E_1$, $E_2$) darstellen ;
— eine gemeinsame Elektrode ($G_L$) für die beiden Kanäle (1, 2) ;
— zweite Mittel, die sog. Übertragungselektroden umfassen, welche die die Übertragung der Ladungen steuernden periodischen Übertragungssignale ($\varnothing_1$, $\varnothing_2$) mit der Periode (T) empfangen, wobei diese Elektroden ggf. derart ausgestaltet sind, dass in jedem der Kanäle die Ladungsgruppen an der gemeinsamen Elektrode ($G_L$) zugeleitet werden mit einer Verzögerung von einer Halbperiode (T/2) in einem Kanal in bezug auf den anderen Kanal ; dadurch gekennzeichnet, dass die ersten Mittel gleichzeitig in je einem Kanal (1, 2) die beiden Eingangssignale ($E_1$, $E_2$) bemustern und dass ferner dritte Mittel (L) vorgesehen sind, die mit der gemeinsamen Elektrode ($G_L$) verbunden sind und ihr Schwimmen in dem Zeitpunkt ($t_6$) erlauben, in dem diese dritten Mittel an der gemeinsamen Elektrode ($G_L$) ein Signals bemustern, welches von der Differenz zwischen den beiden Eingangssignalen ($E_1$, $E_2$) abhängig ist und das Ausgangssignal der Vorrichtung bildet.

2. Differentialvorrichtung nach Anspruch 1, dadurch gekennzeichnet, dass die dritten Mittel (L) in einem ersten Zeitpunkt ($t_4$) ein konstanten Potentials ($V_p$) an die gemeinsame Elektrode (L) beim Eingang ($t_5$) der Ladungsgruppen in dem ersten Kanal unter der Elektrode anlegen, dann in einem zweiten Zeitpunkt die Isolierung der gemeinsamen Elektrode ($G_L$) und das Lesen ihrer Spannung bewirken die sich aus dem vorstehenden konstanten Potential ($V_p$) und aus der Menge der Ladungen ergibt, die unter der Elektrode vorliegen, wenn die Ladungsgruppe in dem zweiten Kanal (2) eingeht, und die Ladungsgruppe, die im ersten Kanal vorhanden ist, abgeht.

3. Differentialvorrichtung nach Anspruch 2, dadurch gekennzeichnet, dass die dritten Mittel (L) einen ersten ($T_p$) und eine zweiten ($T_E$) Transistor des Typs MOS einschliessen, wobei der erste ($T_p$) einerseits mit der gemeinsamen Elektrode ($G_L$) und andererseits mit dem konstanten Potential ($V_p$) verbunden ist, das durch eine erste Spannung ($\varnothing_p$) derselben Periode (T) wie die der Übertragungssignale ($\varnothing_1$, $\varnothing_2$) gesteuert wird, mit einer Phasenverschiebung in bezug auf die letzteren, derart dass die gemeinsame Elektrode ($G_L$) bereits das konstante Potential ($V_p$) erreicht wenn die Ladungsgruppen in dem ersten Kanal (1) eingehen, während der zweite Transistor MOS ($T_E$) über eine seiner Klemmer mit der gemeinsamen Elektrode ($G_L$) verbunden ist, und das Ausgangssignal (S) der Vorrichtung an der anderen seiner Klemmen erscheint, wobei der genannte zweite Transistor durch ein zweites Potential ($\varnothing_{ECH1}$) derselben Periode (T) wie die vorgenannte ($\varnothing_P$) gesteuert wird, welche Periode aber höchstens während der Zeitdauer ihren Höchstwert besitzt, während welcher das erste Potential auf seinen Mindestwert besitzt.

4. Differentialvorrichtung nach einem der vorstehenden Ansprüche, dadurch gekennzeichnet, dass die ersten Mittel für jeden Kanal gebildet werden durch eine im Substrat angeordnete Diode (D), durch eine erste ($G_{EC}$) und eine zweite (GE) Elektrode (oder Gitter), die im wesentlichen parallel zu den Übertragungselektroden liegen, wobei das Eingangssignal (E) des Kanals an die Diode (D) angelegt ist und das erste Gitter ($G_{EC}$) durch ein für beide Kanäle identisches periodisches Potential ($\varnothing_{ECH2}$) gesteuert wird dessen Periode (T) derjenigen der Übertragungssignale ($\varnothing_1$, $\varnothing_2$) gleich ist, wodurch die Bemusterung des Eingangssignals (E) ermöglicht wird.

5. Differentialvorrichtung nach einem der vorstehenden Ansprüche, dadurch gekennzeichnet, dass jede Übertragungselektrode in zwei Elektroden aufgeteilt ist, die durch dasselbe Übertragungssignal gesteuert werden, wobei die genannten Elektroden unter Zwischenschaltung von Schichten (5, 6) aus elektrisch isolierendem Material von verschiedener Dicke auf dem Substrat (4) aufgebracht sind, und dieses auf solche Weise, sodass die Übertragung der Ladungen in dem Substrat nur in einer Richtung erfolgen kann.

6. Differentialvorrichtung nach einem der vorstehenden Ansprüche, dadurch gekennzeichnet, dass der gemeinsamen Elektrode ($G_L$) eine zweite ebenfalls gemeinsame Elektrode ($G_T$) vorgeschaltet ist, die auf einem konstanten Potential ($V_G$) gehalten wird, derart, dass die Ladungen in dem Substrat nur auf die allgemeine Elektrode ($G_L$) übertragen werden können.

7. Filter mit Ladungsübertragung in einem Halbleiter beidem ein Eingangssignal (E) mit Hilfe einer Anzahl (N) von Bewertungskoeffizienten gefiltert wird, dadurch gekennzeichnet, dass er umfasst : eine Differentialvorrichtung gemäss Anspruch 1 und zusätzliche Kanäle derart, dass der Filter eben soviele Kanäle wie Filtrierungskoeffizienten hat, wobei die Anzahl der Übertragungselektroden in jedem Kanal so gross ist, dass einerseits die Ladungsgruppen, die durch je einen von zwei benachbarten Kanäle gehen, welche Koeffizienten gleichen Vorzeichens darstellen, in bezug auf einander um die Periode (T) der Übertragungssignale phasenverschoben sind und andererseits die Ladungsgruppen, die durch je einen von zwei Kanälen gehen, welche Koeffizienten entgegengesetzten Vorzeichens darstellen, um eine ungerade Anzahl von Halbperioden (T/2) der Übertragungssignale Phasenverschoben sind.

8. Filter nach Anspruch 7 und einem der vorhergehenden Ansprüche, dadurch gekennzeichnet, dass die Kanäle im wesentlichen parallel zueinander angeordnet sind, wobei ihre Breite die Grösse des entsprechenden Filtrierkoeffizienten bestimmt, wobei jeder Kanal Bemusterungsmittel für das Eingangssignal (E) aufweist, und wobei die gemeinsame Elektrode ($G_L$) sich auf die Gesamtheit der Kanäle erstreckt.

9. Filter nach Anspruch 7, dadurch gekennzeichnet, dass die Kanäle im wesentlichen parallel zueinander angeordnet sind, wobei ihre Breite die Grösse des entsprechenden Filtrierkoeffizienten bestimmt, während die Bemusterungsmittel für des Eingangssignal (E) gemeinsame Mittel für die gesamtheit der Kanäle sind, und die allgemeine Elektrode ($G_L$) aus so vielen elektrisch untereinander verbundenen Elektroden gebiltet ist wie Kanäle vorhanden sind.

10. Filter nach Anspruch 7, dadurch gekennzeichnet, dass die Kanäle im wesentlichen parallel zueinander angeordnet und von der gleichen Breite sind, wobei die Bemusterungsmittel für das Eingangssignal (E) gemeinsame mittel für die Gesamtheit der Kanäle sind, deren jeder in zwei Teile ($L^+$, $L^-$) unterteilt ist, deren Breitenverhältnis den entsprechenden Filtrierkoeffizienten darstellt, und wobei die gemeinsame Elektrode ($G_L$) aus ebensovielen elektrisch untereinander verbundenen Elektroden gebildet wird wie Kanalteile vorhanden sind.

11. Filter nach einem der Ansprüche 9 oder 10, dadurch gekennzeichnet, dass die erste hinter den Bemusterungsmitteln liegende Übertragungselektrode, die auf dem Wege der Ladungen liegt, auch der Gesamtheit der Kanäle zugeordnet ist, wobei deren elektrische Isolierung unter dieser Elektrode beginnt und durch Diffusion von Isoliermateriel erzielt ist.

12. Verzögerungsleitung mit Übertragung von Ladungen in einem Halbleiter, die ein Eingangssignal verzögert, dadurch gekennzeichnet, dass sie einen Korrektionsfilter nach Anspruch 7 einschliesst.

13. Verzögerungsleitung gemäss Anspruch 12, dadurch gekennzeichnet, dass der Korrektionsfilter Kanäle gleicher Breite aufweist, die im wesentlichen parallel zueinander angeordnet sind, wobei jeder Kanal Bemusterungsmittel (I) für, das dem Kanal zugeleitete Signal aufweist, wobei die allgemeine Elektrode ($G_L$) sich über die Gesamtheit der Kanäle erstreckt und das verzögerte Signal ($S_R$) an die Kanäle des Filters angelegt wird unter Zwischenschaltung von Widerstandselementen (R), deren Widerstandswert den Wert des Filtrierkoeffizienten des entsprechenden Kanals bestimmt.

14. Verzögerungsleitung nach Anspruch 12 und einem der Ansprüche 9 oder 10, dadurch gekennzeichnet, dass sie durch Übertragungselektroden gebildet wird, die sich über die Gesamtheit der Kanäle erstrecken, welche in den Weg der Ladungen hinter den Bemusterungsmitteln angeordnet sind.

FIG_1

FIG_4

0 006 053

FIG.2-a (t₀)

FIG.2-b (t₁)

FIG.2-c (t₂)

FIG.2-d (t₃)

FIG.2-e (t₅)

FIG.2-f (t₆)

0 006 053

FIG.3-a

FIG.3-b

FIG.3-C

FIG.3-d

FIG.3-e

# FIG_5

# FIG_6

FIG_7

# FIG_8

# FIG_9